# EUROPEAN PATENT APPLICATION

(11) **EP 1 234 899 A2**
(43) Date of publication of application: **28.08.2002**
(21) Application number: 02003468.2
(22) Date of filing: 14.02.2002
(51) Int. Cl.: C30B 13/00, C30B 29/28

(54) **A single crystal and method of manufacturing same**

(30) Priority: 21.02.2001 JP 2001045120
(71) Applicant: Murata Manufacturing Co., Ltd., Nagaokakyo-shi Kyoto-fu 617-8555 (JP)
(72) Inventor: Sekijima, Takenori, Murata Manufacturing Co., Ltd., Nagaokakyo-shi, Kyoto-fu 617-8555 (JP); Geho, Mikio, c/o Murata Manufacturing Co., Ltd., Nagaokakyo-shi, Kyoto-fu 617-8555 (JP)
(74) Representative: Zinnecker, Armin, Dipl.-Ing.

(57) **Abstract**

A method of manufacturing a single crystal, for example, an oxide single crystal, without using any seed crystal, includes the steps of preparing a raw material polycrystalline rod, and then using either the Floating Zone Method or the Laser Heated Pedestal Growth Method heating and melting the raw material polycrystalline rod to form a molten zone and then cooling and solidifying the molten zone successively in the length direction, wherein a fiber-shaped single crystal, which is 3 mm or smaller in diameter, grows in the direction normal to the densest surface.

## Description

### BACKGROUND OF THE INVENTION

### 1. Field of the Invention

The present invention relates to a single crystal and to a method of manufacturing a single crystal and particularly to a single crystal and to a method of manufacturing a single crystal which is produced by growth in the melt as in the Floating Zone Method, the Laser Heated Pedestal Growth Method, the Micro Pulling Down Method, etc.

### 2. Description of the Related Art

Conventionally, regarding single-crystal materials used in various devices such as electronic devices, high-frequency devices, optical devices, etc., a large single crystal is grown by Czochralski Method (hereinafter referred to as CZ Method), etc., and cut to a desired size. In recent years, higher performance and lower cost of the various devices are desired and accordingly investigation into manufacturing methods of single crystals is rapidly in progress. Under such conditions, techniques for growing single crystals having various sizes directly in conformity with the size of devices have been investigated, including a technique for growing fiber-shaped crystals. For example, the crystal growth of fiber-shaped yttrium iron garnet (Y₃Fe₅O₁₂, hereinafter referred to as YIG) and its related compounds has been investigated (see, for example, Japanese Unexamined Patent Application Publication No. 10-251088). Among the methods for producing fiber-shaped single crystals, there are not only the Floating Zone Method (hereinafter referred to as the "FZ Method"), but also the Laser Heated Pedestal Growth Method (hereinafter referred to as the "LHPG Method"), the Micro Pulling Down Method (hereinafter referred to as the "m-PD Method"), etc.

When a single crystal is grown, the single crystal is generally grown by using a seed crystal so as to have an intended crystal orientation. When single crystals are grown without any seed crystal, the crystals grow in the same way as their nuclei which are naturally generated and function as the seed crystals and then the crystals have random orientations. Because the physical properties of materials are dependent on their crystal orientations, it is very important to grow crystals so as to have their intended orientations. Therefore, in the FZ Method, LHPG Method, and m-PD Method which are typical growing techniques of fiber-shaped single crystals, crystal growth using a seed crystal is performed.

However, in the above conventional techniques, there is a problem that, because seed crystals in which their orientation is set in advance are required to be prepared, etc., the processes become complicated. In particular, regarding the crystal growth of what is called melt and decomposition type compounds in which, when the compounds are heated and melted, they decompose before reaching their intrinsic melting point causing the liquid phase to have a different composition from that of the solid phase, an appropriate quantity of solvent is required to be used. In the case of fiber-shaped single crystals, there is a problem that the composition and quantity of the solvent must be strictly controlled and that much experience is required for the single crystal growth. Regarding this problem, a new Self-adjusting Solvent FZ Method (hereinafter referred to as SSFZ Method) has been developed in which a fluxing agent produced in self-adjustment is used to solve the problem (see Japanese Unexamined Patent Application Publication No. 10-251088). However, the SSFZ Method has a problem in that it takes more time than in ordinary crystal growth.

### SUMMARY OF THE INVENTION

Accordingly, it is a main object of the present invention to provide a method of manufacturing a single crystal in which a single crystal having a fixed orientation can be easily and stably manufactured.

Furthermore, it is another object of the present invention to provide a single crystal which is easily and stably manufactured and has a fixed crystal orientation.

The inventors investigated the relationship between the orientation of growth of fiber-shaped single crystals and the diameters of the crystals, and, as a result, found that, when the fiber-shaped single crystals become 3 mm or smaller in diameter, the densest surface (facet surface) of the crystals is produced in the free surface normal to the growth direction of the crystals even if any seed crystal is used in particular. The fact that the facet surface appears in the free surface normal to the growth direction means that, on the contrary, a surface normal to the facet surface appears in the direction of growth, that is, it is meant that the orientation of growth of the crystals is controlled.

A method of manufacturing a single crystal according to the present invention comprises the steps of preparing a raw material polycrystalline rod; heating and melting the raw material rod to form a molten zone and then cooling and solidifying the molten zone successively in the length direction; and growing a fiber-shaped single crystal, which is 3 mm or smaller in diameter, in the direction normal to the densest surface.

The single crystal is, for example, an oxide single crystal.

Furthermore, the method of manufacturing a single crystal uses, for example, either the Floating Zone Method or the Laser Heated Pedestal Growth Method.

A single crystal according to the present invention is a single crystal produced by forming a molten zone and solidifying the molten zone without using any seed crystal. The single crystal is fiber-shaped and 3 mm or smaller in diameter, and is grown in the direction normal to the densest surface.

A single crystal according to the present invention is, for example, an oxide single crystal.

In a manufacturing method of a single crystal and a single crystal according to the present invention, the densest surface (facet surface) of the crystal appears in the free surface normal to the growth direction of the crystal, a surface normal to the facet surface is caused in the growth direction, and the orientation of growth of the crystal is controlled.

The above object, other objects, characteristics, and advantages of the present invention are made more clear by detailed description of the embodiments of the present invention with reference to the drawings.

### BRIEF DESCRIPTION OF THE DRAWING(S)

Fig. 1 is an elevational schematic illustration in section showing an example of an optical heating apparatus;
Fig. 2 is a horizontal schematic illustration in section of the optical heating apparatus shown in Fig. 1; and
Fig. 3 is a schematic illustration showing one example of a laser heated pedestal device.

### DETAILED DESCRIPTION OF EMBODIMENTS OF THE INVENTION

First of all, a method of manufacturing a single crystal according to the present invention is described.

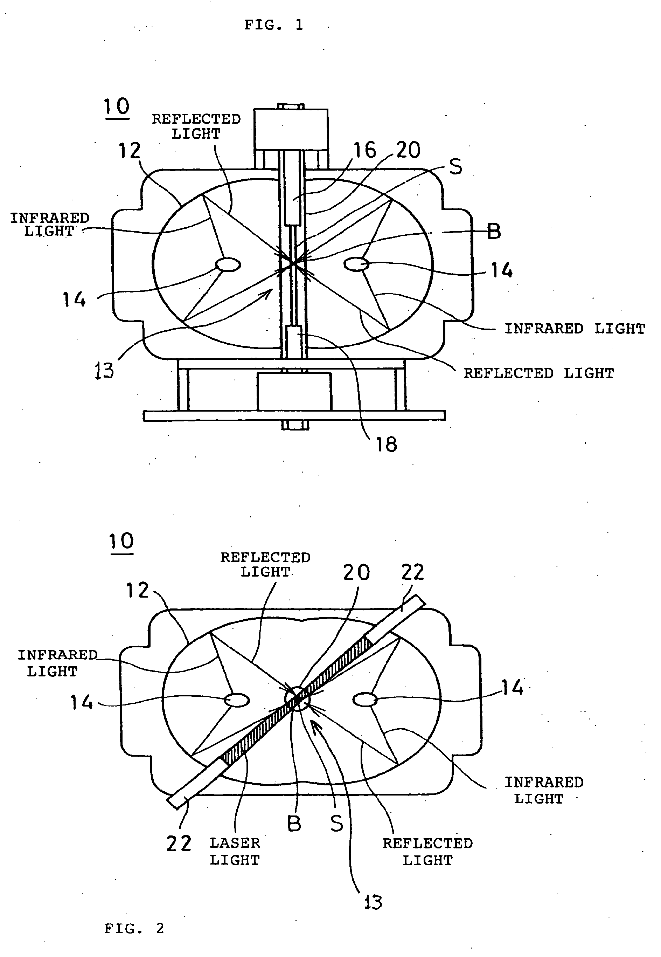

Each of various raw materials is weighed so that a polycrystalline rod as a raw material has a chemical composition of (Y,R)₃Fe₅O₁₂. Here, R represents at least one material selected from Y and rare earth elements of atomic numbers 57 to 71. Each raw material which is weighed is put into a pot together with pebbles and pure water and mixed in the pot for about 24 hours. The mixed raw materials are dehydrated by an aspirator and dried in a drying oven. The dried raw materials are passed through a mesh so that they are of uniform size, and are then provisionally burned in an electric furnace. The provisionally burned raw materials are ground and, after being well mixed and kneaded with an organic binder, the raw materials are molded in a fiber shape by using a molding machine. At this time, the fiber-shaped mold is formed so as to be 3 mm or smaller in diameter. The fiber-shaped mold made of the raw materials is once again put in the electric furnace and sintered to prepare a magnetic garnet polycrystalline rod S as a raw material. Then, the thus prepared magnetic garnet polycrystalline rod S as a raw material is set in an optical heating apparatus shown in Figs. 1 and 2 which is disclosed, for example, in Japanese Unexamined Patent Application Publication No. 10-251088 to manufacture a single crystal using the Floating Zone Method.

Fig. 1 is an elevational schematic illustration in section showing an example of the optical heating apparatus and Fig. 2 is its horizontal schematic illustration in section. The optical heating apparatus 10 shown in Fig. 1 and 2 contains a biellipsoidal mirror 12 the inside of which is gold plated. The biellipsoidal mirror 12 has three focal points arranged in a straight line, the raw material polycrystalline rod S is set so as to pass through the middle focal point 13, and halogen lamps 14 and 14 are set at the other two focal points. Then, the light emitted from the halogen lamps 14 and 14 is reflected by the biellipsoidal mirror 12 and gathered at the focal point 13 where the raw material polycrystalline rod S is disposed in order to heat the raw material polycrystalline rod S. The raw material polycrystalline rod S is set on an upper shaft 16 and a lower shaft 18 so as to be able to move upwards and downwards. Furthermore, a silica tube 20 is set around the upper shaft 16, the lower shaft 18, and the raw material polycrystalline rod S, and, because of this, the atmosphere for growing a single crystal can be arbitrarily adjusted and the biellipsoidal mirror 12 is prevented from being contaminated by evaporation components from the crystal adhering thereto. As an atmosphere gas, for example, an oxygen gas is used in the manufacture of YIG crystals and a nitrogen gas, an argon gas, etc., are used when cerium is used for R. Furthermore, YAG lasers 22 and 22 are set such that the focal point where the raw material polycrystalline rod S is disposed is irradiated with laser light. Because of that, the raw material polycrystalline rod S is irradiated with the laser light from the YAG laser 22 as a heat source to melt the polycrystalline material. In the case of a magnetic garnet, since the melting point is 1700°C or higher, the output of the halogen lamps 14 and the YAG lasers 22 is appropriately selected so that the magnetic garnet is heated to 1700°C or higher. Next, a molten zone B of the raw material polycrystalline rod S is moved to produce a single crystal such that the upper shaft 16 and the lower shaft 18 are moved upwards and downwards in synchronization with each other. The moving speed of the molten zone B at this time is from 1 mm per hour to 30 mm per hour.

Next, the embodiments of single crystals produced by the above method, etc., are described.

### Embodiment 1

In Embodiment 1, a YIG single crystal, which is 3 mm in diameter, was produced by using the optical heating apparatus 10 shown in Figs. 1 and 2 and its orientation was measured by an X-ray Laue camera, and then it was confirmed that the {110} planes, which are a facet surface, exist in the free interface surface normal to the direction of growth.

### Embodiment 2

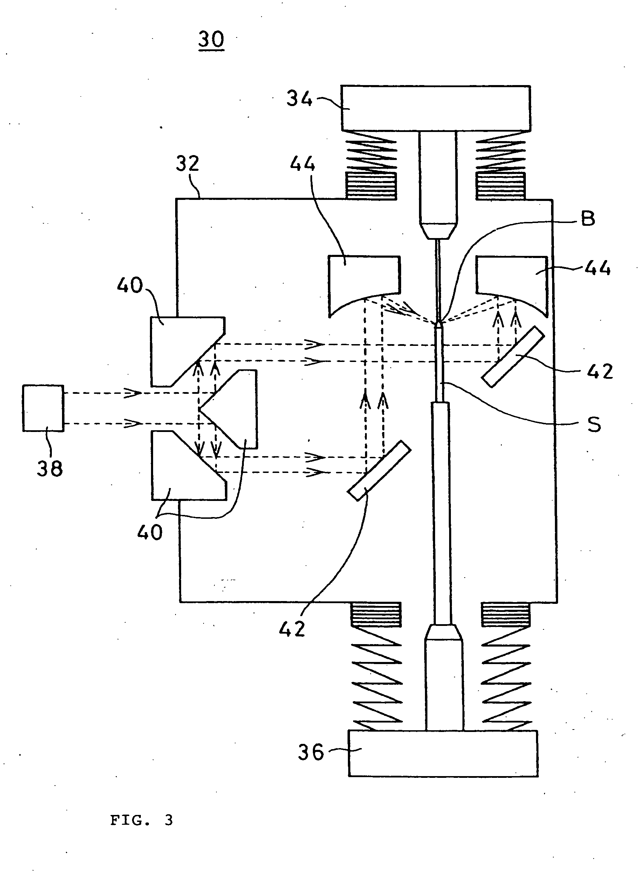

In Embodiment 2, a YIG single crystal, which is 3 mm in diameter, was produced by using the laser heated pedestal device 30 shown in Fig. 3 and its orientation was measured by the X-ray Laue camera, and it was confirmed that the {110} planes, which are a facet surface, exist in the free interface surface normal to the direction of growth.

The laser heated pedestal device 30 shown in Fig. 3 contains a box-type growing chamber 32. A raising mechanism and a supply mechanism are provided in the upper portion and the lower portion of the growing chamber 32. A raw material polycrystalline rod S is set in the raising mechanism 34 and the supply mechanism 36 such that the raw material polycrystalline rod S can move upwards and downwards in the growing chamber 32. A carbon dioxide laser 38 is disposed beside the growing chamber 32. Furthermore, a reflecting cone 40 for reflecting laser light radiated from the carbon dioxide laser 38 is provided in the side portion of the growing chamber 32. Moreover, a reflector 42 for reflecting the laser light and a parabolic mirror 44 for gathering the laser light into the raw material polycrystalline rod S are provided. In this laser heated pedestal device 30, the raw material polycrystalline rod S is melted by the gathered laser light, and the molten zone B of the raw material polycrystalline rod S is moved to produce a single crystal such that the raw material polycrystalline rod S is moved upwards by the raising mechanism 34 and the supply mechanism 36.

### Embodiment 3

In Embodiment 3, a single crystal of tetragonal barium titanate (BaTiO₃, hereinafter referred to as BT), which is 3 mm in diameter, was produced by using the optical heating apparatus 10 shown in Figs. 1 and 2 and its orientation was measured by the X-ray Laue camera, and then it was confirmed that the {110} planes, which are a facet surface, exist in the free interface surface normal to the growth direction.

### Embodiment 4

In Embodiment 4, a single crystal of hexagonal BT, which is 3 mm in diameter, was produced by using the optical heating apparatus 10 shown in Figs. 1 and 2 and its orientation was measured by the X-ray Laue camera, and then it was confirmed that the {110} planes, which are a facet surface, exist in the free interface surface normal to the growth direction.

### Embodiment 5

In Embodiment 5, a single crystal of yttrium aluminum garnet (Y₃Al₅O₁₂, hereinafter referred to as YAG), which is 3 mm in diameter, was produced by using a laser heated pedestal device 30 shown in Fig. 3 and its orientation was measured by the X-ray Laue camera and it was confirmed that the {110} planes, which are a facet surface, exist in the free interface surface normal to the growth direction.

### Example 1 for comparison

In Example 1 for comparison, a YIG single crystal, which is 4 mm in diameter, was produced by using the optical heating apparatus 10 shown in Figs. 1 and 2 and its orientation was measured by the X-ray Laue camera, and then it was confirmed that the {110} planes, which are a facet surface, do not exist in the free interface surface normal to the growth direction.

### Example 2 for comparison

In Example 2 for comparison, a single crystal of tetragonal BT, which is 4 mm in diameter, was produced by using the optical heating apparatus 10 shown in Figs. 1 and 2 and its orientation was measured by the X-ray Laue camera, and then it was confirmed that the {110} planes, which are a facet surface, do not exist in the free interface surface normal to the growth direction.

### Example 3 for comparison

In Example 3 for comparison, a single crystal of hexagonal BT, which is 4 mm in diameter, was produced by using the optical heating apparatus 10 shown in Figs. 1 and 2 and its orientation was measured by the X-ray Laue camera, and then it was confirmed that the {110} planes, which are a facet surface, do not exist in the free interface surface normal to the growth direction.

### Example 4 for comparison

In Example 4 for comparison, a YAG single crystal, which is 4 mm in diameter, was produced by using the laser heated pedestal device 30 shown in Fig. 3 and its orientation was measured by the X-ray Laue camera and it was confirmed that the {110} planes, which are a facet surface, do not exist in the free interface surface normal to the growth direction.

Moreover, the manufacturing method of a single crystal according to the present invention can be applied not only to the manufacturing method of a single crystal of Floating Zone Method using the optical heating apparatus 10 shown in Figs. 1 and 2 and the manufacturing method of a single crystal of Laser Heated Pedestal Growth Method using the laser heated pedestal device 30 shown in Fig. 3, but also to the manufacturing method of a single crystal of Micro Pulling Down Method.

Furthermore, the manufacturing method of a single crystal and the single crystal according to the present invention can be applied to the manufacturing method of a single crystal of lithium niobate (LiNbO₃) and lithium tantalate (LiTaO₃) and the crystal.

According to the present invention, a single crystal grows such that a facet surface is produced in a free surface which is normal to the direction of growth of the crystal without using any seed crystal in particular, and accordingly a single crystal having a fixed orientation can be stably and easily produced.

Although the present invention has been described in relation to particular embodiments thereof, many other variations and modifications and other uses will become apparent to those skilled in the art. It is preferred, therefore, that the present invention be limited not by the specific disclosure herein, but only by the appended claims.

## Claims

1. A method of manufacturing a single crystal without using any seed crystal, comprising the steps of:
(a) preparing a raw material polycrystalline rod; and
(b) heating and melting the raw material polycrystalline rod to form a molten zone and then cooling and solidifying the molten zone successively in the length direction, such that a fiber-shaped single crystal, which is 3 mm or smaller in diameter, grows in the direction normal to the densest surface.

2. The method of manufacturing a single crystal as claimed in claim 1, wherein the single crystal is an oxide single crystal.

3. The method of manufacturing a single crystal as claimed in claim 1 or 2, wherein step (b) is performed using the Floating Zone Method.

4. The manufacturing method of a single crystal as claimed in claim 1 or 2, wherein step (b) is performed using the Laser Heated Pedestal Growth method.

5. A single crystal produced by the method of claims 1 or 2.

6. A single crystal produced by the method of claim 3.

7. A single crystal produced by the method of claim 4.
